(19) Europäisches Patentamt
European Patent Office
Office européen des brevets

(11) Veröffentlichungsnummer: **0 161 592**
**A2**

# (12) EUROPÄISCHE PATENTANMELDUNG

(21) Anmeldenummer: **85105436.1**

(22) Anmeldetag: **03.05.85**

(51) Int. Cl.⁴: **G 03 F 7/02**

(30) Priorität: **12.05.84 DE 3417645**

(43) Veröffentlichungstag der Anmeldung: **21.11.85**
**Patentblatt 85/47**

(84) Benannte Vertragsstaaten: **AT BE CH DE FR GB IT LI NL SE**

(71) Anmelder: **HOECHST AKTIENGESELLSCHAFT,**
**Postfach 80 03 20, D-6230 Frankfurt am Main 80 (DE)**

(72) Erfinder: **Schlögl, Gunter, Dr. Dipl.-Phys., Flinkenweg 2, D-6233 Kelkheim (DE)**
Erfinder: **Mack, Gerhard, Dr. Dipl.-Chem., Mainstrasse 32, D-6200 Wiesbaden (DE)**
Erfinder: **Michel, Manfred, Dr. Dipl.-Chem., Rua Dr. Wilhelm Scheele Nr. 8, C.E.P. 08600 Suzano-Sp. (BR)**

## (54) Lichtempfindliches Aufzeichnungsmaterial für die Herstellung von Flachdruckplatten.

(57) Es wird ein lichtempfindliches Aufzeichnungsmaterial für die Herstellung von Flachdruckplatten beschrieben, das aus einem Schichtträger und einer negativ arbeitenden lichtempfindlichen Schicht besteht, die als lichtempfindliche Verbindung ein Diazoniumsalz-Polykondensationsprodukt und ferner ein farbloses, in Wasser und organischen Lösungsmitteln unlösliches anorganisches Pigment mit einem mittleren Teilchendurchmesser von 1-20 µm in einer Menge von 0,01-2 Gew.%, bezogen auf die nicht flüchtigen Bestandteile der Schicht, in gleichmäßiger Verteilung enthält. Der Pigmentgehalt bewirkt die Ausbildung einer rauhen Schichtoberfläche, durch die die Vakuumanlegezeit im Kopierrahmen verkürzt wird. Die Anwesenheit des Pigments in der Schicht bewirkt ferner eine bessere Tonwertwiedergabe im Druck.

EP 0 161 592 A2

H O E C H S T   A K T I E N G E S E L L S C H A F T
KALLE Niederlassung der Hoechst AG



Lichtempfindliches Aufzeichnungsmaterial für die Herstellung von Flachdruckplatten

Die Erfindung betrifft ein lichtempfindliches Aufzeichnungsmaterial mit einem Schichtträger und einer negativ arbeitenden lichtempfindlichen Schicht, die als lichtempfindliche Verbindung ein Diazoniumsalz-Polykondensationsprodukt enthält und die eine rauhe Oberfläche aufweist.

Vorsensibilisierte Druckplatten, deren Oberfläche einen bestimmten Rauhigkeitsgrad hat, sind bekannt. Diese Platten haben den Vorteil, daß sich bei ihnen die Vakuumkontaktzeit, d. h. die Zeit, die zum Absaugen der Luft im Vakuumkopierrahmen bis zum völlig gleichmäßigen Kontakt zwischen Vorlage und Druckplatte erforderlich ist, wesentlich verkürzen läßt. Mit diesen Platten läßt sich zugleich die Ausbildung von Lufteinschlüssen zwischen Vorlage und Druckplatte vermeiden.

Die rauhe Oberfläche wird in den meisten Fällen dadurch erzeugt, daß man auf die lichtempfindliche Schicht eine zusätzliche Schicht aufbringt, die entweder durch Zusatz von Pigmentpartikeln, durch Prägen mit einer entsprechend gerauhten Oberfläche, z. B. einer Prägewalze, oder auf andere geeignete Weise aufgerauht bzw. mattiert wird. Bei der nachfolgenden Entwicklung wird die mattierte Deckschicht im Entwickler aufgelöst. Materialien dieser Art sind in den DE-A 25 12 043 und 26 38 710 beschrieben. Ein

Nachteil dieser Platten ist es, daß sie eine zweistufige Beschichtung erfordern und daß sich die gesamte Substanz der Deckschicht einschließlich aller gegebenenfalls vorhandener Pigmentpartikel, im Entwickler sammelt, der dadurch rascher unbrauchbar wird.

In der DE-A 29 26 236 werden ähnliche Aufzeichnungsmaterialien mit rauher Oberfläche beschrieben, die in der lichtempfindlichen Schicht Partikel enthalten, deren Durchmesser größer ist als die Schichtdicke. Wenn die Differenz zwischen Partikeldurchmesser und Schichtdicke in einem bestimmten Bereich liegt, wird dadurch ein entsprechender Abstand zwischen Schichtoberfläche und Kopiervorlage erreicht. Da die in der Praxis verwendeten Kopierlampen praktisch nie ideal paralleles Licht aussenden, ist in diesem Fall mit einer leicht unscharfen Abbildung in der Schicht zu rechnen, d. h. es kommt Streulicht auch in Grenzbereiche der lichtempfindlichen Schicht, die bei dichtem Kontakt von der Vorlage abgedeckt wären. Es ist auch möglich, daß je nach Größe, Brechungsindex und Menge der in der Schicht enthaltenen Partikel ähnliche Streu-, Brechungs- oder sogar Beugungserscheinungen durch die Partikel selbst hervorgerufen werden. Alle diese Effekte können bei positiv arbeitenden lichtempfindlichen Schichten zu einer Verkleinerung der bei der Entwicklung stehenbleibenden (unbelichteten) Rasterpunkte führen. Obwohl über diese Belichtungseffekte keine klaren Vorstellungen bestehen, zeigte es sich, daß bei der Belichtung und Entwicklung eines lichtempfindlichen Materials nach DE-A 29 26 236 tatsächlich nachweisbare Unterschiede in der Flächendeckung der entwickelten Druckform auftreten je nachdem, ob die lichtempfindliche Schicht Pigmentpartikel enthält oder nicht. In der folgenden Tabelle sind die prozentualen Flächenbedeckungen, d. h. der Prozentsatz der Oberfläche, der mit Bildelementen bedeckt ist, eines Vorlagenfilms, einer darunter belichteten und entwickelten Druckplatte mit Partikeln in der Schicht und einer ebenso verarbeiteten Druckplatte ohne Partikel in der Schicht gegenübergestellt.

| % Flächenbedeckung | | | | | | | | | | | | |
|---|---|---|---|---|---|---|---|---|---|---|---|---|
| Film | 95 | 89 | 81 | 72 | 63 | 54 | 47 | 38 | 29 | 20 | 12 | 5 |
| Positivschicht mit Partikeln | 99 | 97 | 92 | 86 | 80 | 71 | 62 | 53 | 43 | 31 | 21 | 10 |
| Positivschicht ohne Partikel | 99 | 98 | 94 | 89 | 83 | 74 | 66 | 57 | 47 | 34 | 23 | 11 |

Es ist ersichtlich, daß die Schicht mit Pigmentpartikeln in ihrer Flächenbedeckung, d. h. in ihrer visuell in Erscheinung tretenden optischen Dichte, der Dichte der Vorlage deutlich näher kommt als die entsprechende Schicht ohne Partikel; ihre Tonwertwiedergabe wird in der Praxis als "offener" bezeichnet. Dieses Ergebnis ist erwünscht und als zusätzlicher Vorteil der positiv arbeitenden Materialien nach DE-A 29 26 236 anzusehen.

Nach dieser Kenntnis war zu erwarten, daß bei - umgekehrt arbeitenden - Negativschichten ein entgegengesetzter Effekt auftreten müßte, d. h. der Tonwert der Kopie müßte zunehmen. Da auch bei Negativschichten der Tonwert im Druck stets dichter ist als in dem der Negativvorlage zugrundeliegenden Original, wäre hier eine Verschlechterung der Qualität des Drucks, der mit einer negativ arbeitenden Druckplatte der oben beschriebenen Art erhalten wird, zu erwarten gewesen.

In der Tat ergibt nämlich ein Vergleich einer bekannten negativ arbeitenden Druckplatte mit einer Deckschicht auf der lichtempfindlichen Schicht, die zur Aufrauhung Pigmentpartikel enthält, mit einer sonst gleichen Platte, aber ohne Pigmentpartikel, daß die aus der Platte mit Pigment erhaltene Druckform voller druckt, also einen Druck mit höherer Flächenbedeckung ergibt als die aus der Platte ohne Pigment erhaltene Druckform.

Es war weiterhin zu erwarten, daß bei der Belichtung von Negativplatten, die in der lichtempfindlichen Schicht Partikel enthalten, deren Durchmesser die Schichtdicke überschreitet, die unter einem Partikel liegenden Bereiche der Schicht nicht oder zumindest nicht vollständig gehärtet werden, da die Partikel das Licht absorbieren, reflektieren oder streuen. Da bei einer Schicht, die Partikel enthält, diese in den druckenden Bildteilen der Schicht verbleiben, mußte in diesem Fall damit gerechnet werden, daß die Partikel

nicht fest genug verankert sind und nach verhältnismäßig wenigen Drucken ausbrechen und damit die Druckform unbrauchbar machen.

Es wird angenommen, daß aus diesen Gründen bisher nur solche durch Partikel aufgerauhten Druckplatten Eingang in die Praxis gefunden haben, die entweder positiv arbeiten oder die die Partikel in einer Deckschicht oberhalb der lichtempfindlichen Schicht enthalten, wobei die Deckschicht zusammen mit den Partikeln bei der Entwicklung entfernt wird.

In den wenigen Fällen, in denen auch negativ arbeitende Schichten mit einem Gehalt an Pigmentpartikeln beschrieben sind, handelt es sich gewöhnlich um Platten, bei denen keine hohe Auflösung erforderlich ist, z. B. um photopolymerisierbare Reliefdruckplatten, wie sie die DE-A 24 03 487 beschreibt.

Aufgabe der Erfindung war es, ein für die Herstellung von Flachdruckplatten geeignetes negativ arbeitendes lichtempfindliches Aufzeichnungsmaterial vorzuschlagen, das zur Verkürzung der Vakuumanlegezeit Partikel in der lichtempfindlichen Schicht enthält und das dennoch in Auflösung, Tonwertwiedergabe und Druckauflage der daraus erhaltenen Druckplatte mindestens ebenso gut ist wie ein entsprechendes Material, das keine Pigmentpartikel enthält.

HOECHST AKTIENGESELLSCHAFT
KALLE Niederlassung der Hoechst AG



Die Erfindung geht aus von einem lichtempfindlichen Aufzeichnungsmaterial für die Herstellung von Flachdruckplatten mit einem Schichtträger und einer negativ arbeitenden lichtempfindlichen Schicht, die als lichtempfindliche Verbindung ein Diazoniumsalz-Polykondensationsprodukt enthält und die eine rauhe Oberfläche aufweist.

Das erfindungsgemäße Material ist dadurch gekennzeichnet, daß die lichtempfindliche Schicht ein farbloses, in Wasser und organischen Lösungsmitteln unlösliches anorganisches Pigment mit einem mittleren Teilchendurchmesser von 1 bis 20 $\mu$m in einer Menge von 0,01 bis 2 Gew.-%, bezogen auf die nicht flüchtigen Bestandteile der Schicht, in gleichmäßiger Verteilung enthält.

Überraschenderweise treten die oben beschriebenen zu erwartenden Nachteile bei den mit dem erfindungsgemäßen Material erhaltenen Druckplatten nicht auf. In vielen Fällen ist sogar die Tonwertwiedergabe im Druck offener als bei entsprechenden pigmentfreien Platten. Auch wird in den meisten Fällen die Druckauflage durch den Pigmentzusatz erhöht.

Die Vorteile des erfindungsgemäßen Materials werden besonders dann erzielt, wenn die lichtempfindliche Schicht zusätzlich zu dem Diazoniumsalz-Polykondensationsprodukt noch ein polymeres Bindemittel enthält.

Die Oberfläche der lichtempfindlichen Schicht hat eine Rauhigkeit, die im wesentlichen durch das darin enthaltene Pigment bestimmt wird. Die mittlere Teilchengröße des Pigments sollte stets größer sein als die Schichtdicke. Bevorzugt ist der mittlere Teilchendurchmesser um 1 bis 15 µm größer als die Dicke der Schicht.

Die Schichtdicke der lichtempfindlichen Schicht richtet sich nach dem Verwendungszweck des Materials und entspricht den sonst üblichen Werten. Bei der bevorzugten Anwendung des Materials zur Herstellung von Flachdruckformen liegt sie im allgemeinen zwischen 0,1 und 5, vorzugsweise zwischen 1 und 4 µm.

Die mittlere Teilchengröße der in die lichtempfindliche Schicht eingelagerten Partikel liegt vorzugsweise zwischen 3 und 10 µm. Der Partikelanteil in der Schicht liegt vorzugsweise zwischen 0,1 und 1,0 Gew.-%, bezogen auf den Gesamtgehalt der Schicht an nichtflüchtigen Bestandteilen.

Als Partikel, die gemäß der Erfindung in die lichtempfindliche Schicht eingelagert werden, können solche Substanzen verwendet werden, die mit den Schichtbestandteilen verträglich sind, die Beschichtung des Trägers nicht nachteilig beeinflussen und zusammen mit den unbelichteten Bereichen der lichtempfindlichen Schicht mit Hilfe eines Entwicklers wieder entfernt werden können, ohne mit diesem zu reagieren.

Bevorzugte Beispiele für derartige Partikel sind Teilchen aus Kieselsäure oder Siliciumdioxid, die speziell vorbehandelt sein können, aus Aluminiumoxid, Zinkoxid, Aluminiumsilikat, Aluminiumhydroxid oder Titandioxid. Die Partikel können jeweils aus einer Substanz bestehen, oder es können Partikel aus verschiedenen Substanzen kombiniert werden.

Zur Herstellung der lichtempfindlichen Schichten werden die Teilchen unter gutem Rühren direkt zur Beschichtungslösung gegeben oder gegebenenfalls in einer Kugelmühle zusammen mit einem Teil des Bindemittels, das für die Aufzeichnungsschicht verwendet wird, in einem geeigneten Lösungsmittel dispergiert. Diese Dispersion wird dann dem Rest der vorgesehenen Beschichtungslösung unter gutem Rühren zugefügt.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Grundsätzlich sind alle Diazoniumsalz-Polykondensationsprodukte geeignet, die in der DE-A 27 39 774 beschrieben sind.

Die Diazoniumsalzeinheiten $A-N_2X$ leiten sich bevorzugt von Verbindungen der Formel $(R^1-R^2-)_pR^3-N_2X$ ab, wobei

X das Anion der Diazoniumverbindung,
p eine ganze Zahl von 1 bis 3,
$R^1$ einen aromatischen Rest mit mindestens einer zur Kondensation mit aktiver Carbonylverbindung befähigten Position,
$R^3$ eine Phenylengruppe,
$R^2$ eine Einfachbindung oder eine der Gruppen:

$-(CH_2)_q-NR^4-$,

$-O-(CH_2)_r-NR^4-$,

$-S-(CH_2)_r-NR^4-$,

$-S-CH_2CO-NR^4-$,

$-O-R^5-O-$,

$- O -$

$- S -$ oder

$-CO-NR^4-$

bedeuten, worin

q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist.

Die bevorzugten erfindungsgemäßen Aufzeichnungsmaterialien enthalten, wie bereits erwähnt, ein polymeres Bindemittel. In diesem Falle enthält die lichtempfindliche Schicht im allgemeinen 5 bis 90, bevorzugt 10 bis 70 Gew.-% Diazoniumverbindung und 95 bis 10, bevorzugt 90 bis 30 Gew.-% polymeres Bindemittel, bezogen auf die gesamten nichtflüchtigen Schichtbestandteile.

Als Bindemittel werden wasserunlösliche, in organischen Lösungsmitteln lösliche Polymere bevorzugt. Beispiele sind Polyvinylacetat, Polyvinylacetale, Polyurethane, Epoxidharze und Acryl- bzw. Methacrylsäureesterpolymere. Mit besonderem Vorteil werden Bindemittel verwendet, die in verdünnten wäßrig-alkalischen Lösungen löslich sind, da mit ihnen eine Entwicklung mit rein wäßrigen Lösungen ohne Zusatz organischer Lösungsmittel möglich ist. Beispiele für derartige Bindemittel sind Phenolharze, Polyvinylphenole, Mischpolymerisate von Acryl- bzw. Methacrylsäure mit Estern dieser Säuren, Mischpolymerisate von Styrol und Maleinsäureanhydrid, Polymere mit seitenständigen Sulfonylurethangruppen und Reaktionsprodukte von Dicarbonsäureanhydriden mit Hydroxylgruppen enthaltenden Polymeren.

Die zuletztgenannten Reaktionsprodukte werden besonders bevorzugt. Als Dicarbonsäureanhydride kommen insbesondere Malein-, Phthal-, Bernstein- und 3-Oxaglutarsäureanhydrid in Betracht; als Hydroxylgruppen enthaltende Polymere werden solche mit Vinylalkohol-

H O E C H S T  A K T I E N G E S E L L S C H A F T
KALLE Niederlassung der Hoechst AG



einheiten, aber auch Cellulosepartialether oder -ester, Epoxidharze und verseifte Epoxidharze, Copolymere von Allylalkohol oder höheren ungesättigten Alkoholen, Polyhydroxyalkylacrylate und -methacrylate bevorzugt, wobei Polymere mit Vinylalkoholeinheiten, wie teilverseifte Polyvinylester, Polyvinylacetale mit freien Hydroxygruppen sowie entsprechende Umsetzungsprodukte von Copolymeren mit Vinylester- oder Vinylacetal- oder Vinylalkoholeinheiten besonders vorteilhaft sind.

Die Molekulargewichte dieser Umsetzungsprodukte liegen im allgemeinen zwischen 5.000 und 200.000, vorzugsweise zwischen 10.000 und 100.000. Die Säurezahl beträgt im allgemeinen 5 bis 80, bevorzugt 10 bis 70. Diese Carboxylgruppen enthaltenden Reaktionsprodukte sind in der älteren deutschen Patentanmeldung P 34 04 366.7 beschrieben.

Zur Stabilisierung der lichtempfindlichen Schicht ist es vorteilhaft, dieser eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Schichten können ferner Weichmacher, Haftvermittler, Farbstoffe, Pigmente und Farbbildner zugesetzt werden.

Art und Menge dieser Zusätze richten sich nach dem für das lichtempfindliche Aufzeichnungsmaterial vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Schichten können ferner Farbstoffe und/oder Farbpigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Viktoriareinblau FGA (C.I. Basic Blue 81), Renolblau B2G-H (C.I. 74160), Kristallviolett oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Im Rahmen der Erfindung wird folgende gewichtsmäßige Verteilung der wichtigsten Zusätze in der lichtempfindlichen Schicht bevorzugt:

| | | |
|---|---|---|
| Bindemittel | : | 30 bis 90 % |
| Diazoniumsalz-Polykondensationsprodukt | : | 10 bis 70 % |
| Pigmentpartikel | : | 0,01 bis 2 % |
| Säure | : | 0 bis 10 % |
| Farbstoff | : | 0 bis 12 % |
| Belichtungskontrastgeber (Farbstoff) | : | 0 bis 5 % |

Die Beschichtung des Trägermaterials erfolgt aus entsprechenden organischen Lösemitteln oder Lösemittelgemischen, und zwar im allgemeinen durch Gießen, Sprühen oder Eintauchen.

Als Lösemittel sind Alkohole, Ketone, Ester, Ether und dergleichen geeignet. Als günstige Lösemittel haben sich dabei die Partialether der Glykole oder der Ketoalkohole erwiesen, z. B. Ethylenglykolmonomethylether.

Das lichtempfindliche Aufzeichnungsmaterial dient bevorzugt zur Herstellung von Flachdruckformen, wobei als Trägermaterial Aluminium bevorzugt wird.

Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der Aufzeichnungsmaterialien erfolgt in bekannter Weise durch bildmäßiges Belichten und Auswaschen der unbelichteten Schichtbereiche mit einem geeigneten Entwickler.

Die Belichtung des Kopiermaterials erfolgt in bekannter Weise unter einer Vorlage mit Kopierlichtquellen, die

einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren.

Die Entwicklung erfolgt je nach der Natur der Schichtbestandteile mit wäßrigen Lösungen oder organischen Lösemitteln. Wäßrige Lösungen werden im allgemeinen bevorzugt. Zur Entwicklung der besonders bevorzugten Schichten mit alkalilöslichen Bindemitteln werden wäßrig-alkalische Lösungen mit einem pH-Wert im Bereich von 8 bis 14, vorzugsweise 9 bis 12, verwendet, die Puffersalze, z. B. wasserlösliche Alkaliphosphate, -silikate, -borate, -carbonate, -acetate oder -benzoate, enthalten. Als weitere Bestandteile können Netzmittel, vorzugsweise anionische Netzmittel, und ggf. wasserlösliche Polymere verwendet werden. Die Lösung kann auch geringe Mengen, z.B. bis zu 5, bevorzugt nicht mehr als 2 Gew.-% an mit Wasser mischbaren organischen Lösemitteln enthalten. Bevorzugt werden schwerflüchtige Lösemittel, z.B. araliphatische Alkohole, deren Dampfdruck bei der Handhabung des Entwicklers nicht ins Gewicht fällt.

Die Entwicklung kann in bekannter Weise durch Tauchen, Besprühen, Bürsten oder Tamponieren erfolgen.

H O E C H S T   A K T I E N G E S E L L S C H A F T
KALLE Niederlassung der Hoechst AG



Von der so hergestellten Druckform können Drucke mit sehr hoher Auflage hergestellt werden.

Mit Hilfe der erfindungsgemäß hergestellten pigmenthaltigen Kopierschicht und eines geeigneten Schichtträgers wird ein Kopiermaterial mit einer rauhen oder unebenen Schichtoberfläche erhalten, mit der es möglich wird, ein Diapositiv in innigen Kontakt mit der lichtempfindlichen Schicht zu bringen, wobei die für das Entlüften des Vakuumkopierrahmens notwendige Zeit erheblich vermindert wird. Dieser Vorteil wird erreicht, ohne daß es aufgrund von zurückbleibenden Lufteinschlüssen zwischen Schichtoberfläche und Kopiervorlage zu Unterstrahlungen kommt. Das erfindungsgemäße Material läßt sich wesentlich einfacher herstellen als bisher für den gleichen Zweck bekannte negativ arbeitende Materialien. Es ist nur eine Beschichtung unter üblichen Bedingungen erforderlich, und die Schichtoberfläche bedarf keiner nachträglichen Bearbeitung, z. B. einer Prägung.

Gegenüber den mit einer unebenen mattierungsmittelhaltigen lichtunempfindlichen Deckschicht versehenen Kopierschichten oder gegenüber Druckplatten, die auf der lichtempfindlichen Schicht zusätzlich ein unebenes regelmäßiges Muster haben, besitzen die erfindungsgemäß hergestellten Druckplatten einen größeren Belichtungsspielraum.

Die folgenden Beispiele sollen die Erfindung erläutern. Gewichtsteile und Volumteile stehen im Verhältnis von g/ccm, Prozentangaben und Mengenverhältnisse sind in Gewichtseinheiten zu verstehen, wenn nichts anderes angegeben ist.

Beispiel 1

Man löst

1,7 Gt des Umsetzungsprodukts eines Polyvinylbutyrals mit einem Molekulargewicht von 70.000 - 80.000, das 71 Gew.-% Vinylbutyral-, 2 Gew.-% Vinylacetat- und 27 Gew.-% Vinylalkoholeinheiten enthält, mit Propenylsulfonylisocyanat,

0,6 Gt eines Diazoniumsalz-Polykondensationsproduktes aus 1 mol 3-Methoxy-diphenylamin-4-diazoniumsulfat und 1 mol 4,4'-Bis-methoxymethyl-diphenylether, ausgefällt als Mesitylensulfonat,

0,09 Gt Viktoriareinblau FGA (C.I. Basic Blue 81) und

0,07 Gt Phosphorsäure (85 %)

in 60 Gt 2-Methoxy-ethanol und 20 Gt Butylacetat und gibt dazu 0,015 Gt feinteilige Kieselsäure mit einem mittleren Teilchendurchmesser von 8 µm.

Diese Lösung wird 5 Minuten in einem Ultraschallbad (48 kHz) behandelt, um Agglomerate zu zerteilen.

Mit Hilfe einer Schleuder wird ein elektrolytisch aufgerauhtes, anodisiertes und mit Polyvinylphosphonsäure behandeltes Aluminiumblech mit dieser Lösung beschichtet, wobei ein Schichtgewicht von 1,0 g/m$^2$ erhalten wird.

Eine weitere Druckplatte wird in gleicher Weise hergestellt, jedoch ohne Zusatz von Kieselsäure.

Zur Herstellung von Druckformen werden diese Druckplatten unter einer transparenten Filmvorlage mit Rasterfeldern verschiedener prozentualer Flächenbedeckung bildmäßig belichtet und anschließend mit der folgenden Lösung entwickelt:

5 Gt Natriumlaurylsulfat,
1,5 Gt Natriummetasilikat x 5 $H_2O$,
1 Gt Trinatriumphosphat x 12 $H_2O$,
92,5 Gt Wasser.

Während die Kieselsäure enthaltende Druckplatte im Kopierrahmen bereits nach 20 s Vakuumzeit in vollständige Berührung mit der Filmvorlage gebracht werden konnte, ohne daß beim Belichten ungleichmäßige Unterstrahlungseffekte auftraten, gelang es mit der Vergleichsplatte erst nach 1-2 Minuten Vakuumzeit, den innigen Kontakt mit der Filmvorlage herzustellen.

Auf beide Kopierschichten, die die gleiche Lichtempfindlichkeit aufweisen, wurden innerhalb der gleichen Belichtungszeit Rasterfelder aufbelichtet.

Nach dem Entwickeln wurden die beiden Druckformen in einer Offsetdruckmaschine nebeneinander gedruckt. Die Farbstärke wurde an der Druckmaschine so eingestellt, daß auf dem Druckbogen über die gesamte Breite beider Bilder die gleiche Volltondichte gemessen wurde. Die prozentuale Flächendeckung (F) wurde mit einem Densitometer gemessen. In der Tabelle sind die prozentualen Flächendeckungen des Vorlagenfilms sowie von je einem Druckbogen wiedergegeben, der mit einer der zuvor beschriebenen Druckformen erhalten wurde. Da es sich um eine Negativvorlage handelt, sind die bei ihr gemessenen Prozentsätze von 100 subtrahiert worden, so daß sich bei Vorlage und Kopie vergleichbare Dichtewerte ergeben.

| | % Flächendeckung | | | | | | | | | | | |
|---|---|---|---|---|---|---|---|---|---|---|---|---|
| Film (100-F) | 5 | 11 | 19 | 28 | 37 | 46 | 53 | 62 | 71 | 80 | 88 | 95 |
| Schicht mit Partikeln (F) | 18 | 29 | 42 | 54 | 64 | 74 | 79 | 84 | 89 | 94 | 97 | 100 |
| Schicht ohne Partikel (F) | 18 | 31 | 43 | 56 | 66 | 76 | 80 | 85 | 90 | 94 | 98 | 99 |

HOECHST AKTIENGESELLSCHAFT
KALLE Niederlassung der Hoechst AG



Beispiel 2

Man löst

1,2 Gt des Umsetzungsprodukts des in Beispiel 1 angegebenen Polyvinylbutyrals mit Maleinsäureanhydrid (Säurezahl: 30),

1,2 Gt eines Diazoniumsalz-Polykondensationsproduktes aus 3-Methoxy-diphenylamin-4-diazoniumsulfat und Formaldehyd,

0,02 Gt Phenylazodiphenylamin und

0,3 Gt Renolblau B2G-H (C.I. 74160)

in 97,3 Gt 2-Methoxyethanol und gibt dazu 0,015 Gt feinteilige Kieselsäure mit einem mittleren Teilchendurchmesser von 8 µm.

Diese Lösung wird 5 Minuten in einem Ultraschallbad (48 kHz) behandelt, um Agglomerate zu zerteilen.

Mit Hilfe einer Schleuder wird ein elektrolytisch aufgerauhtes, anodisiertes und mit Polyvinylphosphonsäure behandeltes Aluminiumblech mit dieser Lösung beschichtet, wobei ein Schichtgewicht von 1,0 g/$m^2$ erhalten wird.

Zum Vergleich wird eine sonst gleiche Druckplatte ohne Partikelzusatz hergestellt.

Zur Herstellung einer Druckform werden die Druckplatten unter einer transparenten Filmvorlage mit Rasterfeldern abgestufter prozentualer Flächenbedeckung bildmäßig belichtet und anschließend mit der in Beispiel 1 angegebenen Lösung entwickelt.

Während die unter Partikelzusatz hergestellte Druckplatte im Kopierrahmen bereits nach 20 s Vakuumzeit in vollständige Berührung mit der Filmvorlage gebracht werden konnte, ohne daß beim Belichten ungleichmäßige Unterstrahlungseffekte auftraten, gelang es mit der Vergleichsplatte ohne Pigmentzusatz erst nach 1 - 2 Minuten Vakuumzeit, den innigen Kontakt mit der Filmvorlage herzustellen.

Auf diese beiden Kopierschichten gleicher Lichtempfindlichkeit wurden mit gleicher Belichtungszeit Rasterfelder aufbelichtet.

Nach dem Entwickeln wurden die beiden Druckformen in einer Offsetdruckmaschine nebeneinander gedruckt. Die Farbstärke wurde an der Druckmaschine so eingestellt, daß auf dem Druckbogen über beide Bilder die gleiche Volltondichte gemessen wurde. Die prozentuale Flächenbedeckung wurde mit einem Densitometer gemessen. In der Tabelle sind die prozentualen Flächenbedeckungen des Vorlagenfilms sowie von je einem Druckbogen wiedergegeben, der mit einer der zuvor beschriebenen Druckformen erhalten wurde.

H O E C H S T   A K T I E N G E S E L L S C H A F T
KALLE  Niederlassung der Hoechst AG



| | % Flächendeckung | | | | | | | | | | | |
|---|---|---|---|---|---|---|---|---|---|---|---|---|
| Film (100-F) | 5 | 11 | 19 | 28 | 37 | 46 | 53 | 62 | 71 | 80 | 88 | 95 |
| Schicht mit Partikeln (F) | 16 | 26 | 38 | 50 | 60 | 71 | 76 | 83 | 87 | 93 | 97 | 99 |
| Schicht ohne Partikel (F) | 16 | 27 | 39 | 51 | 61 | 71 | 77 | 84 | 89 | 94 | 98 | 100 |

Beispiel 3

In einer Lösung von

2,1 Gt Polyvinylformal mit einem mittleren Molekulargewicht von 30000 und einem Gehalt von etwa 7 % Vinylalkoholeinheiten, 30 % Vinylacetateinheiten und 50 % Vinylformaleinheiten,

0,6 Gt des in Beispiel 1 angegebenen Diazoniumsalz-Polykondensationsprodukts,

0,06 Gt 85 %ige Phosphorsäure und

0,3 Gt Kupferphthalocyanin in

96,9 Gt 2-Methoxy-ethanol

werden 0,015 Gt der in Beispiel 1 angegebenen Kieselsäure wie dort beschrieben dispergiert.

Die erhaltene Beschichtungslösung wird auf eine wie in Beispiel 1 vorbehandelte Aluminiumplatte aufgeschleudert und getrocknet. Das Schichtgewicht beträgt 1 $g/m^2$. Eine weitere Druckplatte wird in gleicher Weise, jedoch ohne Zusatz von Kieselsäure hergestellt.

Beide Druckplatten werden, wie in Beispiel 1 beschrieben, unter einer Vorlage belichtet und mit einer Lösung aus

1 Gt 2-n-Butoxy-ethanol,
21 Gt n-Propanol und
78 Gt Wasser

entwickelt.

Beide Druckformen wurden auf einer Offsetdruckmaschine wie in Beispiel 1 nebeneinander gedruckt. In der folgenden Tabelle sind die Flächenbedeckungen des Vorlagenfilms sowie von je einem von diesen Druckplatten erhaltenen Druckbogen in Prozent angegeben.

| | Flächendeckung in % | | | | | | | | | | | |
|---|---|---|---|---|---|---|---|---|---|---|---|---|
| Vorlage (100-F) | 5 | 11 | 19 | 28 | 37 | 46 | 53 | 62 | 71 | 80 | 88 | 95 |
| mit $SiO_2$ (F) | 15 | 25 | 36 | 49 | 59 | 71 | 76 | 82 | 87 | 93 | 97 | 100 |
| ohne $SiO_2$ (F) | 15 | 25 | 37 | 48 | 59 | 72 | 77 | 82 | 88 | 94 | 98 | 100 |

Beispiel 4 (Vergleichsbeispiel)

Eine vorsensibilisierte Druckplatte wurde hergestellt, wie es in Beispiel 1 für die Vergleichsplatte beschrieben ist, d. h. ohne Kieselsäurepigment in der lichtempfindlichen Schicht.

Eine Lösung von

| | |
|---|---|
| 2,8 | Gt Polyvinylalkohol und |
| 0,06 | Gt nichtionischem Netzmittel in |
| 97,12 | Gt Wasser |

wurde mit 0,021 Gt der in Beispiel 1 angegebenen feinteiligen Kieselsäure versetzt, und die Dispersion wurde 5 Minuten mit Ultraschall behandelt.

Ein Teil der oben beschriebenen Druckplatte wurde mit der erhaltenen Dispersion beschichtet und getrocknet.

Ein weiterer Teil der Druckplatte wurde mit der Polyvinylalkohollösung ohne Zusatz von Kieselsäure beschichtet und getrocknet. In beiden Fällen hatte die Deckschicht ein Schichtgewicht von 1 $g/m^2$.

Beide Druckplatten wurden, wie in Beispiel 1 beschrieben, unter einem Rasterstufenkeil belichtet, entwickelt und nebeneinander in eine Druckmaschine eingespannt.

H O E C H S T   A K T I E N G E S E L L S C H A F T
KALLE Niederlassung der Hoechst AG



In der folgenden Tabelle sind die prozentualen Flächendeckungen der Vorlage und der beiden Druckbogen angegeben, die mit den beiden beschriebenen Druckformen gedruckt wurden.

| | Flächendeckung in % | | | | | | | | | | | |
|---|---|---|---|---|---|---|---|---|---|---|---|---|
| Film (100-F) | 5 | 11 | 19 | 28 | 37 | 46 | 53 | 62 | 71 | 80 | 88 | 95 |
| Deckschicht mit $SiO_2$ (F) | 14 | 25 | 38 | 51 | 61 | 71 | 76 | 83 | 88 | 93 | 98 | 100 |
| Deckschicht ohne $SiO_2$ (F) | 13 | 25 | 37 | 49 | 59 | 69 | 74 | 80 | 86 | 92 | 96 | 100 |

Die Tabelle zeigt, daß in diesem Fall, in dem die Druckplatte eine pigmentierte Deckschicht hatte, wie es im Stand der Technik beschrieben ist, die Flächendeckung im Druck bei Kieselsäurezusatz höher ist als ohne diesen Zusatz. Dieses Ergebnis entspricht dem, was der Fachmann auch für eine Druckplatte aus dem erfindungsgemäßen Aufzeichnungsmaterial erwartet hätte.

HOECHST AKTIENGESELLSCHAFT
KALLE Niederlassung der Hoechst AG



## Patentansprüche

1. Lichtempfindliches Aufzeichnungsmaterial für die Herstellung von Flachdruckplatten mit einem Schichtträger und einer negativ arbeitenden lichtempfindlichen Schicht, die als lichtempfindliche Verbindung ein Diazoniumsalz-Polykondensationsprodukt enthält und die eine rauhe Oberfläche aufweist, dadurch gekennzeichnet, daß die lichtempfindliche Schicht ein farbloses, in Wasser und organischen Lösungsmitteln unlösliches anorganisches Pigment mit einem mittleren Teilchendurchmesser von 1 bis 20 $\mu$m in einer Menge von 0,01 bis 2 Gew.-%, bezogen auf die nicht flüchtigen Bestandteile der Schicht, in gleichmäßiger Verteilung enthält.

2. Lichtempfindliches Aufzeichnungsmaterial nach Anspruch 1, dadurch gekennzeichnet, daß die Dicke der lichtempfindlichen Schicht 0,1 bis 5 $\mu$m beträgt.

3. Lichtempfindliches Aufzeichnungsmaterial nach Anspruch 1, dadurch gekennzeichnet, daß der mittlere Durchmesser der Teilchen um 1 bis 15 $\mu$m größer ist als die Dicke der Schicht.

4. Lichtempfindliches Aufzeichnungsmaterial nach Anspruch 1, dadurch gekennzeichnet, daß das anorganische Pigment aus Kieselsäure, Aluminiumoxid, Aluminiumsilikat, Aluminiumhydroxid, Titandioxid oder Zinkoxid besteht.

H O E C H S T   A K T I E N G E S E L L S C H A F T
KALLE Niederlassung der Hoechst AG



5. Lichtempfindliches Aufzeichnungsmaterial nach Anspruch 1, dadurch gekennzeichnet, daß die lichtempfindliche Schicht ferner ein polymeres Bindemittel enthält.

6. Lichtempfindliches Aufzeichnungsmaterial nach Anspruch 5, dadurch gekennzeichnet, daß das Bindemittel in Wasser unlöslich und in verdünnten wäßrig-alkalischen Lösungen löslich ist.

7. Lichtempfindliches Aufzeichnungsmaterial nach Anspruch 6, dadurch gekennzeichnet, daß das Bindemittel ein Umsetzungsprodukt eines intramolekularen Anhydrids einer organischen Polycarbonsäure mit einem Hydroxylgruppen enthaltenden Polymeren ist, das keine weiteren zur Umsetzung mit Säureanhydriden befähigten funktionellen Gruppen enthält.

8. Lichtempfindliches Aufzeichnungsmaterial nach Anspruch 1, dadurch gekennzeichnet, daß das negativ arbeitende Diazoniumsalz-Polykondensationsprodukt aus wiederkehrenden Einheiten $A-N_2X$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines

aromatischen Kohlenwasserstoffs, einer aromatischen heterocyclischen Verbindung oder eines organischen Säureamids ist.

Wi.